# EUROPÄISCHE PATENTSCHRIFT

(11) **EP 3 718 128 B1**
(45) Veröffentlichungstag und Bekanntmachung des Hinweises auf die Patenterteilung: **15.09.2021**
(21) Anmeldenummer: 18812136.2
(22) Anmeldetag: 30.11.2018
(51) Int. Cl.: H01J 37/32, C23C 16/04

(54) **VORRICHTUNG ZUM BESCHICHTEN VON BEHÄLTERN MIT MINDESTENS EINEM VENTILBLOCK**
DEVICE FOR COATING CONTAINERS, COMPRISING AT LEAST ONE VALVE BLOCK
DISPOSITIF DE REVÊTEMENT DE RÉCIPIENTS POURVUS D'AU MOINS UN BLOC DE SOUPAPE

(30) Priorität: 01.12.2017 DE 102017128550
(43) Veröffentlichungstag der Anmeldung: 07.10.2020
(73) Patentinhaber: KHS Corpoplast GmbH, 22145 Hamburg (DE)
(72) Erfinder: MÜLLER, Hartwig, 22952 Lütjensee (DE); BRZEZINSKI, Milosz, 23863 Bargfeld-Stegen (DE)
(74) Vertreter: DTS Patent- und Rechtsanwälte Schnekenbühl und Partner mbB
(86) Internationale Anmeldenummer: PCT/EP2018/083075
(87) Internationale Veröffentlichungsnummer: WO 2019/106120

(56) Entgegenhaltungen:
- WO-A1-03/100125
- WO-A1-2011/153993
- WO-A2-03/100121

## Beschreibung

Die vorliegende Erfindung betrifft eine Vorrichtung zum Beschichten von Behältern mit mindestens einem Ventilblock.

Solche Vorrichtungen werden beispielsweise bei der Vakuumsteuerung eines Siliciumoxid-Beschichtungsprozesses, insbesondere bei der Plasma-CVD-Beschichtung von PET-Flaschen, verwendet. Mit einer solchen Beschichtung werden Barrieresyteme für verschiedene Anwendungsformate realisiert. Bevorzugt werden O₂-, CO₂- und H₂O-Barrieren auf PET-Flaschen aufgebracht. Da dieses Verfahren im Vakuum stattfindet, ist es notwendig, die verschiedenen Vakuumstränge über Vakuumventile zu steuern. Diese unterliegen besonderen Anforderungen und Verschleiß.

Aus der WO 03/100125 A1 ist eine Vorrichtung zur Plasmabeschichtung von Behältern bekannt. Zur Beschichtung wird der Behälter in eine zumindest teilweise evakuierbare Kammer einer Behandlungsstation eingesetzt und dort von einem Halteelement positioniert von einem Halteelement positioniert. Zur elichzeitigen Versorgung von mindestens zwei Kammern mit mindestens einem Betriebsmittel wird eine Strömung des Betriebsmittels mindestens einmal in mindestens zwei Teilströme verzweigt.

Aus der WO 03/100121 A2 ist eine ähnliche Vorrichtung bekannt, bei der durch eine kompakte Anordnung der Ventile in einem Ventilblock Verschließteile leicht ausgetauscht werden können.

Aus dem Stand der Technik ist beispielsweise bereits eine Vorrichtung zur Plasmabehandlung von Werkstücken gemäß der DE 10 2010 023 119 A1 beziehungsweise der WO 2011/153993 A1 bekannt. Die Vorrichtung hat einen Ventilblock, der einem Vakuumblock mit einer Vertiefung und eine dazu verschwenkbare Tragplatte, die Steuerventile trägt, aufweist. In der Vertiefung sind Absaugleitungen zur Erzeugung eines Abgasstroms vorhanden. Die Tragplatte weist eine Arbeits- und eine Wartungsposition auf, wobei sich die unteren Enden der Steuerventile im Prozessgasstrom befinden. Die Steuerventile befinden sich in der Arbeitsposition innerhalb der Vertiefung und in der Wartungsposition außerhalb der Vertiefung. In der Vakuumtechnik werden üblicherweise Eckventile mit Faltenbälgen verwendet. Die Faltenbälge sind in der Regel nicht dauerfest. Deshalb wird statt Faltenbälgen ein Abschirmsystem nach dem Labyrinth-Prinzip eingesetzt. Die Teile der Vakuumventile, die sich im Bereich der vorbeiströmenden Prozessgase befinden, werden mit SiO beschichtet und müssen deshalb regelmäßig gereinigt werden; Dichtungen und Führungen verschleißen und müssen ausgetauscht werden. Der dafür notwendige Montage- und Reinigungsaufwand ist erheblich. Es kann günstiger sein, anstatt dessen, kostenoptimierte, neue Teile einzusetzen. Die von Verschmutzung oder Verschleiß betroffenen Teile sind in einer Ventilpatrone zusammengefasst, die über ein Bajonettsystem schnell austauschbar sind. Der überwiegende Teil der Vakuumventile ist auf einer Tragplatte montiert. Nach dem Aufschwenken der Tragplatte sind die Ventilpatronen von der Unterseite her zugänglich und entnehmbar. Die Entfernung der Ventilpatronen zu Service- bzw. Austauschzwecken ist allerdings aufwendig, da zum Einsetzen der Patronen eine genaue Positionierung in Umfangsrichtung einzuhalten ist und aufgrund des Bajonettverschlusses eine Verdrehung vorgenommen werden muss.

Es ist die Aufgabe der vorliegenden Erfindung, die Vorrichtung so weiterzubilden, dass eine einfachere Ersetzung der Verschleißteile der Vakuumventile in einer solchen Beschichtungsvorrichtung ermöglicht wird.

Diese Aufgabe wird erfindungsgemäß gelöst durch eine Vorrichtung mit den Merkmalen des Anspruchs 1. Danach ist vorgesehen, dass der Ventilblock einen Vakuumblock mit einer Vertiefung aufweist, in der Absaugleitungen vorhanden sind, so dass ein Abgasstrom entsteht. Außerdem weist die Vorrichtung eine Tragplatte auf, an der eine Mehrzahl von Vakuumventilen in Aufnahmeöffnungen angeordnet sind, wobei die Tragplatte bezüglich des Vakuumblocks eine Arbeitsposition und eine Wartungsposition aufweist. Die unteren Enden der Vakuumventile, die sich im Strom des Prozessgases befinden, sind in der Arbeitsposition innerhalb der Vertiefung angeordnet und befinden sich in der Wartungsposition außerhalb der Vertiefung. Dadurch kann auf diese Teile der Vakuumventile sehr einfach zugegriffen werden, wenn die Vorrichtung nicht betrieben wird. Erfindungsgemäß ist an der Tragplatte ein Verriegelungsrahmen angeordnet, der zwischen einer Verriegelungsposition und einer Entriegelungsposition relativ zur Tragplatte bewegbar ist, so dass die Vakuumventile in der Verriegelungsposition unlösbar mit der Tragplatte verbunden sind und in der Entriegelungsposition von der Tragplatte abnehmbar sind. Dadurch können zur Wartung der Teile der Vakuumventile, die hohem Verschließ ausgesetzt sind, die betroffenen Teile sehr einfach aus der Vorrichtung entnommen und bei Bedarf ausgetauscht werden. Gleichzeitig wird sichergestellt, dass die Vakuumventile während des Betriebs der Vorrichtung sicher an ihrem Platz sind.

Eine vorteilhafte Weiterbildung der Erfindung sieht vor, dass der Verriegelungsrahmen einen Hebelmechanismus aufweist, der an der Tragplatte in einem Lager gelagert ist, und mit dem die Bewegung des Verriegelungsrahmens zwischen seiner Verriegelungsposition und seiner Entriegelungsposition erfolgt. Eine solche Ausgestaltung ist mechanisch sehr stabil und ermöglicht eine fehlerfreie Bedienung des Verriegelungsrahmens hinsichtlich seiner Bewegung zwischen Verriegelungs- und Entriegelungsposition. Die Bedienung des Verriegelungsmechanismus kann dadurch mittels einer einzigen Handbewegung erfolgen.

Eine weitere vorteilhafte Weiterbildung der Erfindung sieht vor, dass der Hebelmechanismus einen Rast- oder Sperrbolzen aufweist. Dadurch wird ein unbeabsichtigtes Entriegeln der Vakuumventile verhindert.

Eine weitere vorteilhafte Weiterbildung der Erfindung sieht vor, dass der Verriegelungsrahmen in einer Führung mit Führungsnuten linear verschiebbar gelagert ist. Dies stellt eine sehr einfache Ausgestaltung zur Herstellung der erfindungsgemäß benötigten Bewegungsmöglichkeit dar und kann in sehr einfacher Ausgestaltung mittels zweier Führungsnuten in der Tragplatte erreicht werden. Bei einer linearen Verschiebung des Verriegelungsrahmens, ist es je nach Stellung des Hebels des Hebelmechanismus möglich, alle auf einem Ventildeckel angeordneten Vakuumventile gleichzeitig freizugeben bzw. zu verriegeln.

Eine weitere vorteilhafte Weiterbildung der Erfindung sieht vor, dass der Verriegelungsrahmen erste Abschnitte aufweist, die erste Durchbrechungen aufweisen, die so groß sind und so weit voneinander beabstandet sind, dass sie in der Entriegelungsposition des Verriegelungsrahmens die Aufnahmeöffnungen für die Vakuumventile nicht überdecken, und zweite Abschnitte mit zweiten Durchbrechungen aufweist, die jeweils nebeneinander liegende erste Abschnitte miteinander verbinden und die in der Verriegelungsposition des Verriegelungsrahmens die Aufnahmeöffnungen für die Vakuumventile teilweise überdecken. Dadurch wird mittels einfacher mechanischer Mittel eine sehr sichere Festlegung der Vakuumventile in der Verriegelungsposition und gleichzeitig eine problemlose Möglichkeit zur Entfernung der Vakuumventile in der Entriegelungsposition gewährleistet, wobei gleichzeitig die Bewegung zwischen Verriegelungsposition und Entriegelungsposition problemlos durchgeführt werden kann.

Eine weitere vorteilhafte Weiterbildung der Erfindung sieht vor, dass die Vakuumventile jeweils eine Ringnut aufweisen, die so mit den zweiten Abschnitten des Verriegelungsrahmens zusammenwirken, dass die Begrenzungen der zweiten Durchbrechungen in der Verriegelungsposition in die Ringnuten eingreifen. Eine solche Ausgestaltung ermöglicht das sichere Festlegen der Vakuumventile in der Verriegelungsposition durch eine formschlüssige Verbindung des jeweiligen Vakuumventils mit der Tragplatte über den Verriegelungsrahmen.

Eine weitere vorteilhafte Weiterbildung der Erfindung sieht vor, dass die Vakuumventile jeweils eine Ventilpatrone aufweisen, in der ihre Verschleißteile zusammengefasst sind, wobei an der Ventilpatrone bevorzugt die Ringnut ausgebildet ist. Dadurch ist es möglich, mit einem Handgriff sämtliche Verschleißteile eines Vakuumventils auszutauschen.

Eine weitere vorteilhafte Weiterbildung der Erfindung sieht vor, dass der Vakuumblock mit der Tragplatte über ein Schwenkgelenk verbunden ist. Aufgrund des Schwenkgelenks ist es nicht nötig, eine zusätzliche präzise Positionierung der Tragplatte in dem Vakuumblock vorzunehmen, wenn die Tragplatte von ihrer Wartungsposition in die Arbeitsposition gebracht wird; diese erfolgt automatisch. Dadurch wird auch gewährleistet, dass sich die unteren Enden der Vakuumventile in der Arbeitsposition wieder exakt an der richtigen Stelle innerhalb der Vertiefung im Vakuumblock befinden, um ein optimales Arbeitsergebnis zu erzielen.

Eine weitere vorteilhafte Weiterbildung der Erfindung sieht vor, dass eine lösbare Schraube zwischen Vakuumblock und Tragplatte, insbesondere an der Tragplatte, angeordnet ist. Die Schraube dient dazu, die Tragplatte in ihrer Arbeitsposition am Vakuumblock festzulegen. Die Vorrichtung kann so ausgebildet sein, dass die Schraube zum Verschließen der für die Aufnahme der Vakuumventile ausgebildeten Tragplatte nur zugänglich ist, wenn die Vakuumventile mit dem Hebelmechanismus an der Tragplatte verriegelt wurden.

Eine weitere vorteilhafte Weiterbildung der Erfindung sieht vor, dass die Schraube nur in ihrem Endbereich ein Gewinde aufweist und ihr Schaft ansonsten ohne das Gewinde ausgeführt ist. Dadurch kann die Schraube zum einen in vertikaler Richtung zur Tagplatte 6 bewegt werden und mit ihrem Gewinde mit einem an der Grundplatte vorhandenem Gegengewinde verschraubt werden, so dass während eines Schwenkens der Grundplatte gegenüber dem Vakuumblock feststeht, und zum anderen so mit einem entsprechend geformten Bügel an dem Verriegelungsrahmen zusammenwirken, dass der Verriegelungsrahmen zwischen seiner Verriegelungsposition und seiner Entriegelungsposition nur hin und her bewegt werden, wenn die Schraube in dem Gegengewinde der Grundplatte eingeschraubt ist. Dadurch wird verhindert, dass eine solche Bewegung stattfinden kann, wenn sie dies nicht sollte.

Eine weitere vorteilhafte Weiterbildung der Erfindung sieht vor, dass ein Luftzufuhrkanal so ausgestaltet ist, dass er sowohl in dem Vakuumblock als auch in der Tragplatte verläuft und immer unterbrochen ist, wenn sich die Tragplatte nicht in ihrer Arbeitsposition befindet. Eine nicht verschlossene Tragplatte kann keine Druckluft zu den Pilotventilen der Vakuumventile weiterleiten. Damit ist ein versehentliches Schalten der Vakuumventile ausgeschlossen. Dies kann beispielsweise in Form einer Trennstelle der Luftzufuhr realisiert werden, wobei die Vakuumventile unter Luftdruck stehen, falls der Ventilblock samt Vakuumventilen geöffnet wird, ohne vorher die Luftzufuhr unterbrochen zu haben.

Alle in den Unteransprüchen angegebenen Merkmale der vorteilhaften Weiterbildungen sind sowohl für sich jeweils einzeln als auch in beliebigen Kombinationen zur Erfindung gehörig.

Weitere Einzelheiten und Vorteile der Erfindung werden anhand eines in den Zeichnungen dargestellten Ausführungsbeispiels näher erläutert.

Es zeigen:
- Fig. 1: Ansicht einer erfindungsgemäßen Beschichtungsanlage mit einer Beschichtungsstation;
- Fig. 2: vergrößerte Teilansicht der Beschichtungsanlage aus Fig. 1 im Bereich der Beschichtungsstation;
- Fig. 3: vergrößerte Darstellung der Beschichtungsstation aus Fig. 2 im Bereich ihres Ventilblocks mit geöffneter Tragplatte;
- Fig. 4: Ansicht eines Ventilblocks mit geschlossener Tragplatte;
- Fig. 5: Ansicht eines erfindungsgemäßen Verriegelungsrahmens;
- Fig. 6: Ansicht einer Ventilpatrone;

- Fig. 7: Ansicht einer Tragplatte mit eingebautem Verriegelungsrahmen in seiner Entriegelungsposition und
- Fig. 8: Ansicht wie in Fig. 8 mit dem Verriegelungsrahmen in seiner Verriegelungsposition.

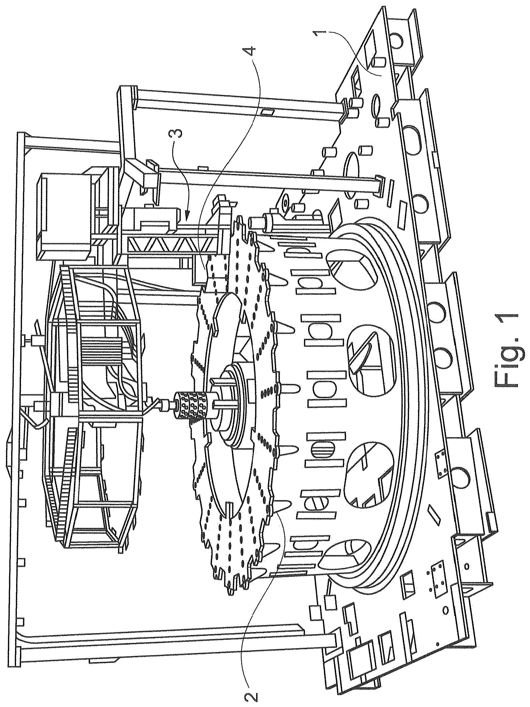

Fig. 1 zeigt eine perspektivische Ansicht einer erfindungsgemäßen Beschichtungsvorrichtung mit einer Plattform 1, auf der sich ein Beschichtungsrad 2 befindet. Oberhalb des Beschichtungsrades 2 sind 20 Beschichtungsstationen 3 angeordnet, von denen zur besseren Erkennbarkeit nur eine dargestellt ist. Die Beschichtungsstation 3 weist einen Ventilblock 4 auf. Insoweit entspricht die Beschichtungsvorrichtung denjenigen, die aus dem Stand der Technik bekannt sind. Das Erfinderische liegt in der Ausgestaltung des Ventilblocks 4; dies wird weiter unten näher beschrieben.

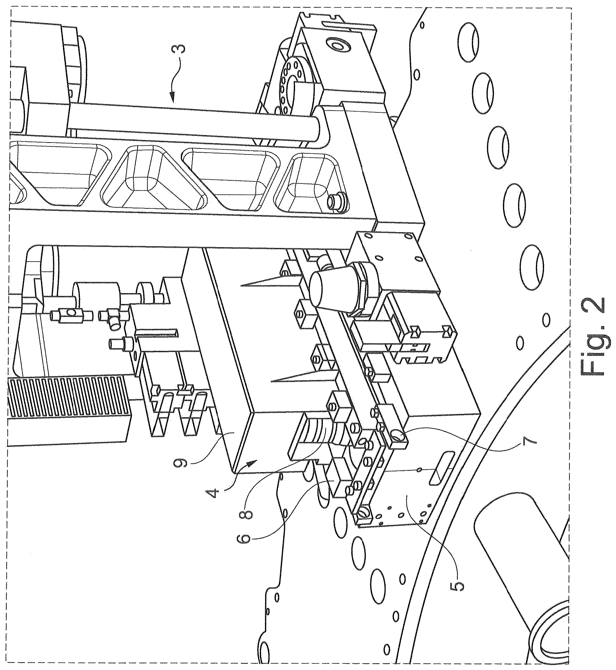

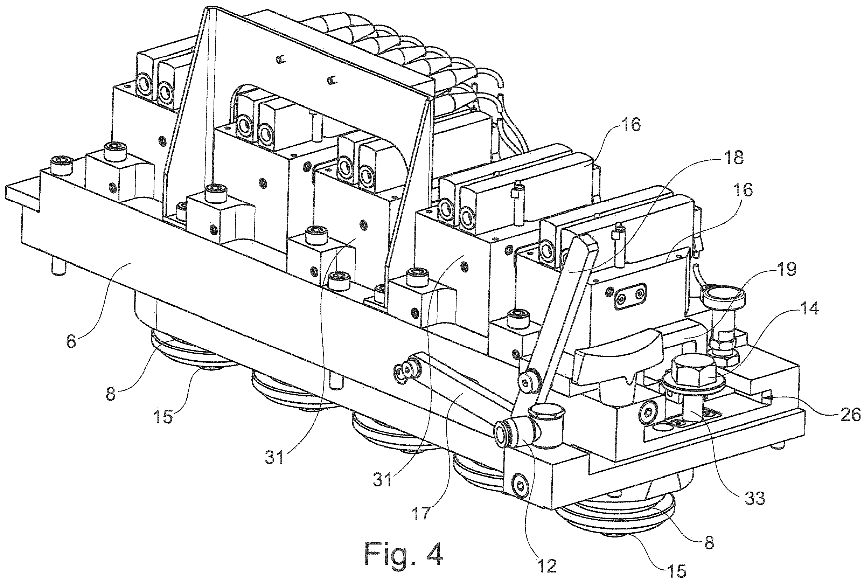

Fig. 2 zeigt einen vergrößerten Ausschnitt der Fig. 1 im Bereich der Beschichtungsstation 3. Die Beschichtungsstation 3 weist einen Vakuumblock 5 und eine damit um ein Schwenkgelenk 7 schwenkbar verbundene Tragplatte 6 auf. Der Ventilblock 4 ist mit der Tragplatte 6 verbunden, wobei an der Tragplatte 6 Vakuumventile 16 (siehe Fig. 4) angeordnet sind, von denen in Fig. 2 nur eine Ventilpatrone 8 zu sehen ist. Die Vakuumventile 16 werden von einer Haube 9 eingehaust, um diese gegen Verschmutzung und mechanische Beschädigung zu schützen.

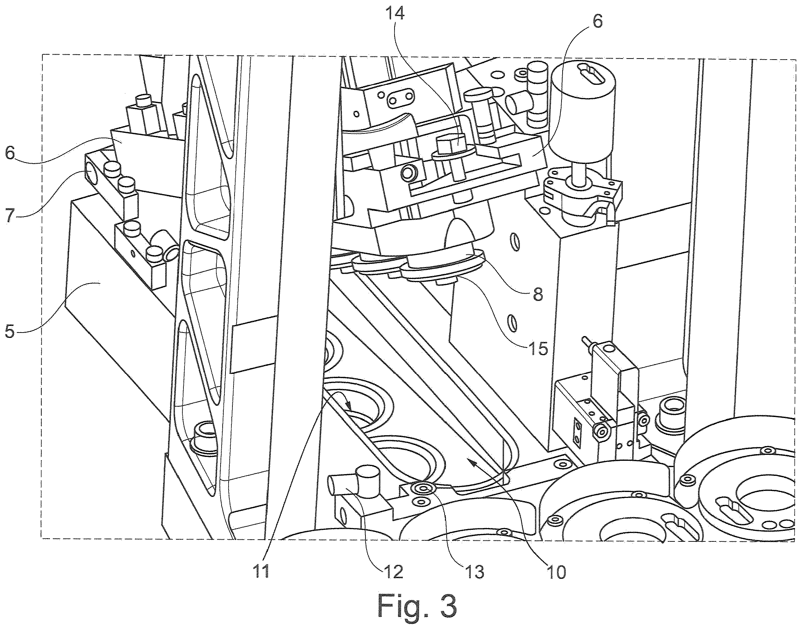

Fig. 3 zeigt einen vergrößerten Ausschnitt der Fig. 2 im Bereich des Ventilblocks 4 von rechts hinten in der Fig. 2 gesehen. Im Unterschied zu Fig. 2 ist die Tragplatte 4 um das Schwenkgelenk 7 nach oben von dem Vakuumblock 5 weggeschwenkt. Sie befindet sich in ihrer Wartungsposition, wohingegen sie in Fig. 2 (und auch in Fig. 4) in ihrer Arbeitsposition gezeigt wird.

In dem Vakuumblock 5 sind Absaugleitungen 11 zu erkennen, durch die einen Abgasstrom aus den Vakuumventilen 16 (siehe Fig. 4) geführt wird. Diese

Absaugleitungen 11 sind in einer Vertiefung 10 des Vakuumblocks 5 ausgebildet. In der Arbeitsposition der Tragplatte 6 befinden sich die unteren Enden 15 der Ventilpatronen 8 genau oberhalb der Absaugleitungen 11. An dem dem Betrachter zugewandten Ende der Tragplatte 6 ist eine Schraube 14 angeordnet, die, wenn sich die Tragplatte 6 in der Arbeitsposition befindet, fest mit einem (nicht dargestellten) Schraubgewinde im Vakuumblock 5 verschraubt wird.

Am Vakuumblock 5 ist eine Luftzufuhr 12 ausgebildet, die dazu dient, Druckluft zu den Pilotventilen der Vakuumventile 16 weiterzuleiten. Die Zufuhr der Luft über diese Luftzufuhr 12 in den Ventilblock 4 wird beim Öffnen des Ventilblocks 4 - also, wenn die Tragplatte 6 von ihrer Arbeitsposition in ihre Wartungsposition geschwenkt wird - unterbrochen, um zu verhindern, dass die Vakuumventile 16 unter Luftdruck stehen, wenn der Ventilblock 4 geöffnet wird, ohne vorher die Zufuhr der Luft unterbrochen zu haben. Dies wird durch eine Ausbildung eines sich an die Luftzufuhr 12 anschließenden Luftzufuhrkanal 13 erreicht, der teilweise in der Tragplatte 6 und teilweise im Vakuumblock 5 verläuft. Damit ist ein versehentliches Schalten der Vakuumventile 16 ausgeschlossen.

In Fig. 4 ist nur der Teil des Ventilblocks 4 dargestellt, der mit der Tragplatte 6 verbunden ist. An der Tragplatte 6 sind fünf Vakuumventile 16 angeordnet, deren untere Enden 15, die baulich zu Ventilpatronen 8 gehören, nach unten über die Tragplatte 6 herausstehen (dieser Teil befindet in der Arbeitsposition der Tragplatte 6 in der Vertiefung 10 des Vakuumblocks 5). Die Ventilpatronen 8 sind idealerweise in jeweils einem Ventilgehäuse 31 angeordnet.

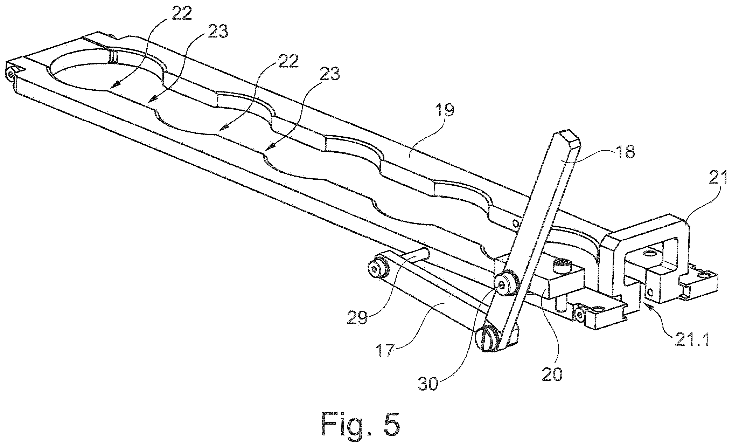

Es ist auch ein Hebelmechanismus 17 dargestellt, der in der Tragplatte 6 gelagert ist und mit einem Verriegelungsrahmen 19 verbunden ist. Mittels eines Betätigungshebels 18, der Bestandteil des Hebelmechanismus 17 ist, wird der Verriegelungsrahmen 19 linear in zwei in der Tragplatte 6 ausgebildeten Führungsnuten 26 verschoben. Dieser Mechanismus wird weiter unten anhand der Figuren 5 sowie 7 und 8 näher erläutert.

In Fig. 4 sind auch noch die Luftzufuhr 12 und die Schraube 14 zu sehen, die oben schon im Zusammenhang mit Fig. 3 näher beschrieben wurden.

Fig. 5 zeigt den Verriegelungsrahmen 19 ohne die in Fig. 4 dargestellten Teile der Tragplatte 6. Der Verriegelungsrahmen 19 ist abgesehen von dem Hebelmechanismus 17 aus vier Teilen zusammengesetzt, die mittels Schrauben miteinander verbunden sind. Es handelt sich um zwei spiegelverkehrt zueinander ausgebildete Längsstücke, die parallele zueinander verlaufen und über ein in derselben Ebene liegendes Querstück am linken Ende miteinander verbunden sind, sowie einen senkrecht zu der Ebene, in der die anderen drei Teile verlaufen, das rechte Ende der Längsstücke verbindenden Bügel 21.

Zwischen den Längsstücken sind somit abwechselnd erste Abschnitte mit ersten Durchbrechungen 22 und zweite Abschnitte mit zweiten Durchbrechungen 23 ausgebildet. Die ersten Durchbrechungen 22 sind an ihren Begrenzungen - durch die Längsstücke sowie bei der ganz linken ersten Durchbrechung 22 zusätzlich durch das Querstück gebildet - in der Draufsicht kreisbogenförmig ausgebildet, wobei die zu derselben ersten Durchbrechung 22 gehörigen Abschnitte auf einem gemeinsamen Kreis liegen, der sich virtuell in die angrenzende zweite Durchbrechung 23 bzw. die angrenzenden zweiten Durchbrechungen 23 erstrecken. Die zweiten Durchbrechungen 23 werden durch parallel zueinander verlaufende Flächen an den beiden Längsstücken gebildet. Der Abstand zwischen den beiden Längsstücken im Bereich der zweiten Durchbrechungen 23 ist geringer als der Durchmesser der (virtuellen) Kreise der ersten Durchbrechungen 22. Es sind insgesamt fünf erste Durchbrechungen 22 vorhanden, zwischen denen sich jeweils eine zweite Durchbrechung 23 erstreckt. Dabei entspricht idealerweise die Erstreckung einer ersten Durchbrechung 22 und einer benachbarten zweiten Durchbrechung 23 entlang der Längsstücke gerade dem Hub des Verriegelungsrahmens 19 zwischen der Arbeitsposition und der Wartungsposition.

Der Bügel 21 am rechten Ende des Verriegelungsrahmens 19 hat eine solche Form, dass der Kopf der Schraube 14 samt deren Gewindestück und dem Schaft 33 hindurchpasst, wenn die Schraube 14 nicht in dem Vakuumblock 5 festgezogen ist. Die Schraube 14 weist nur in ihrem unteren Endbereich ein Gewinde auf, der zwischen dem Kopf der Schraube 14 und dem Schraubgewinde befindliche Schaft 33 ist glatt, ohne Gewinde ausgebildet. Die Tragplatte 6 ist in dem Bereich, in dem die Schraube 14 sie durchdringt, mit einem Gegengewinde versehen, das mit dem Gewinde am unteren Ende der Schraube 14 verschraubbar ist; hingegen ist der Schaft 33 im Durchmesser so gering, dass er in diesem Gegengewinde mit geringem Spiel laufen kann. Bevor die Grundplatte 6 von dem Vakuumblock 5 weggeschwenkt wird (der weggeschwenkte Zustand ist in Fig. 3 dargestellt), wird das Gewinde der Schraube 14 in das Gegengewinde der Tragplatte 6 eingeschraubt, damit die Schraube 14 beim Schwenken feststeht,

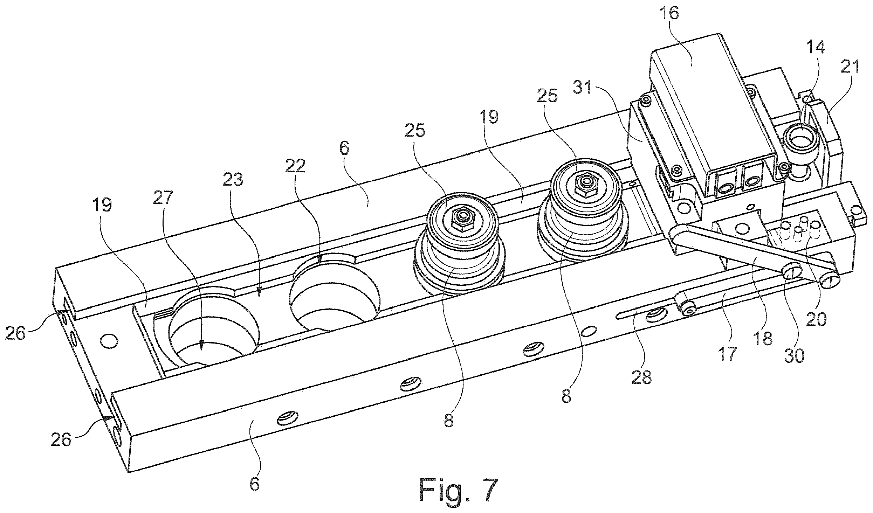

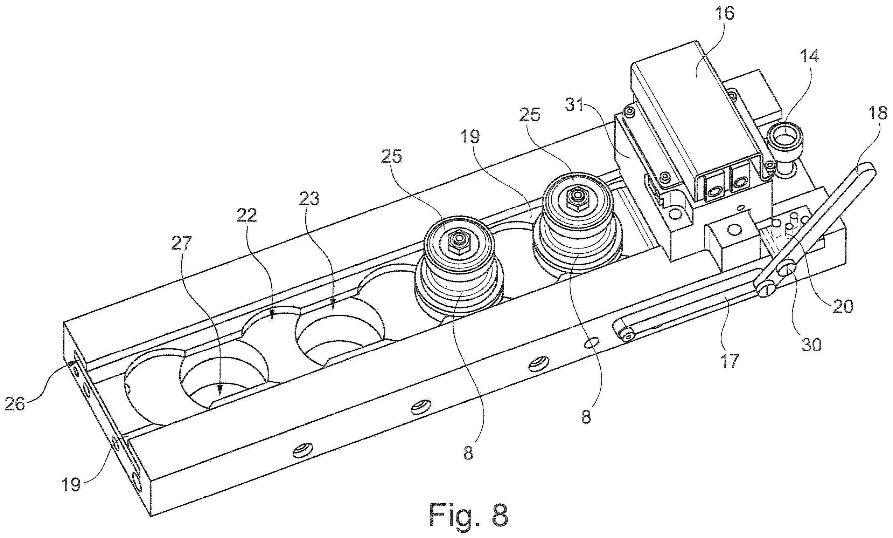

Am vorderen Längsstück des Verriegelungsrahmens 19 ist der Hebelmechanismus 17 über eine Stange 29 verbunden. Am Betätigungshebel 18 ist über eine Achse 30 ein Lager 20 vorhanden, das mit der Tragplatte 6 fest verbunden wird (siehe Figuren 7 und 8).

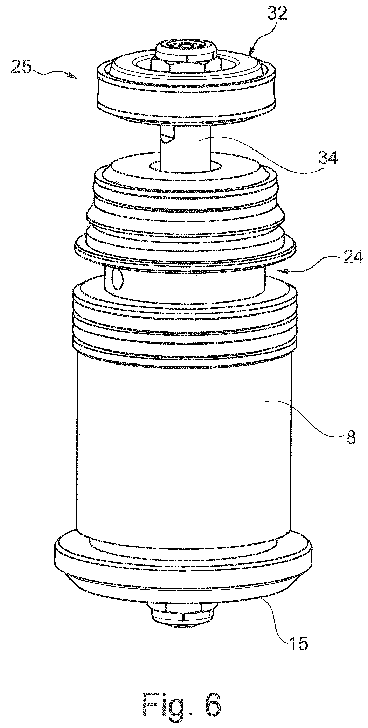

In Fig. 6 ist eine Ventilpatrone 8 vergrößert dargestellt. In ihr sind die Verschleißteile des Vakuumventils 16 zusammengefasst, so dass diese Verschließteile einfach ausgetauscht werden können, indem die ganze Ventilpatrone 8 ausgetauscht wird. Das untere Ende 15 steht, wie oben schon zu Fig. 3 ausgeführt über das untere Ende der Tragplatte 6 heraus und taucht in der Arbeitsposition der Tragplatte 6 in die Vertiefung 10 des Vakuumblocks 5 ein. Das obere Ende 25 der Ventilpatrone 8 befindet sich im eingebauten Zustand in einem zylindrischen Teil des Ventilgehäuses 31, in dem ein als Kolben 32 ausgebildeter Teil der Ventilpatrone 8 mitsamt dem oberen Ende 25 der Ventilpatrone 8 in vertikaler Richtung läuft. Der Kolben 32 läuft auch innerhalb der Ventilpatrone 8 in vertikaler Richtung und wird von einer Kolbenstange 33 geführt.

Für die Erfindung wesentlich ist eine Ringnut 24 an der Ventilpatrone 8. Diese hat eine Breite (in Fig. 6 erstreckt sich diese Breite in der Vertikalen), die geringfügig größer ist als die Dicke der Längsstücke des Verriegelungsrahmens 19 (dies ist die vertikale Ausdehnung der Längsstücke in Fig. 5). Die Funktion der Ringnut 8 an den jeweiligen Ventilpatronen 8 wird anhand der Figuren 7 und 8 im Folgenden näher erläutert.

In den Figuren 7 und 8 ist der Verriegelungsrahmen 19 in seinem in die Tragplatte 6 eingebauten Zustand dargestellt, wobei zusätzlich jeweils ein ganzes Vakuumventil 16 (siehe auch Fig. 4) mit jeweils einem zugeordneten Ventilgehäuse 31 und zwei Ventilpatronen 8 ohne die mit zugehörigen Ventilgehäuse 31 dargestellt sind. Die beiden weiteren Vakuumventile 16 sind zur Veranschaulichung der Funktionsweise der Erfindung weggelassen. Fig. 7 zeigt den Verriegelungsrahmen 19 in seiner entriegelten Position und Fig. 8 zeigt ihn in seiner verriegelten Position.

In Fig. 7 ist die entriegelte Position des Verriegelungsrahmens 19 dargestellt. In dieser Position ist der Betätigungshebel 18 des Hebelmechanismus 17 in seiner linken Anschlagstellung. Die Achse 30 des Hebelmechanismus 17 ist über das Lager 20 fest mit der Tragplatte 6 verbunden. Dadurch ist die Stange 29 (siehe Fig. 5), die mit dem Verriegelungsrahmen 19 verbunden ist, innerhalb eines Führungsschlitzes 28 an ihrem rechten Anschlag und hat somit den Verriegelungsrahmen 19 innerhalb der beiden Führungsnuten 26 der Tragplatte 6 in seine rechte Extremstellung gebracht. In dieser Extremstellung liegen die (kreisförmigen) ersten Durchbrechungen 22 des Verriegelungsrahmens 19 fluchtend über den Aufnahmeöffnungen 27 der Tragplatte 6. In dieser Stellung können die Ventilpatronen 8 nach unten durch die Aufnahmeöffnungen 27 herausgezogen werden. Der Verriegelungsrahmen 19 nimmt diese Stellung ein, wenn sich die Tragplatte 6 in ihrer Wartungsposition - also von dem Vakuumblock 5 weggeschwenkt - befindet.

Um zu verhindern, dass die Tragplatte 6 in dieser Position des Verriegelungsrahmens 19 nach einem Verbringen in ihre Arbeitsposition mit dem Vakuumblock 5 fest verschraubt werden kann - was nötig ist, um den Betrieb aufnehmen zu können -, ist der Bügel 21 am Verriegelungsrahmen 19 über die Schraube 14 nach rechts geschoben worden. In dieser Konstellation kann die Schraube 14 nicht mit einem Schraubenschlüssel gedreht werden, da dieser vom Bügel 21 abgehalten wird.

In Fig. 8 ist die verriegelte Position des Verriegelungsrahmens 19 dargestellt. In dieser Position ist der Betätigungshebel 18 des Hebelmechanismus 17 in seiner rechten Anschlagstellung. Dadurch ist die mit dem Verriegelungsrahmen 19 verbundene Stange 29 (siehe Fig. 5) innerhalb des (verdeckten) Führungsschlitzes 28 (siehe Fig. 7) an ihrem linken Anschlag und hat somit den Verriegelungsrahmen 19 innerhalb der beiden Führungsnuten 26 der Tragplatte 6 um seinen Hub in seine linke Extremstellung gebracht. In dieser Extremstellung liegen die zweiten Durchbrechungen 23 des Verriegelungsrahmens 19 fluchtend über den Aufnahmeöffnungen 27 der Tragplatte 6. In dieser Stellung können die Ventilpatronen 8 nicht mehr nach unten durch die Aufnahmeöffnungen 27 herausgezogen werden, da die Begrenzungen der zweiten Durchbrechungen 23 in die Ringnuten 24 der Ventilpatronen 8 eingreifen. Der Verriegelungsrahmen 19 nimmt diese Stellung ein, wenn sich die Tragplatte 6 in ihrer Arbeitsposition - also auf den Vakuumblock 5 geschwenkt - befindet. In dieser Position des Verriegelungsrahmens 19 ist der Bügel 21 (nicht zu sehen, da er von dem Vakuumventil 16 verdeckt wird) nach links gewandert und gibt den Kopf der Schraube 14 frei, damit dieser mittels eines geeigneten Werkzeugs angezogen bzw. gelöst werden kann und somit eine Fixierung bzw. Lösung der Tragplatte 6 von dem Vakuumblock 5 erfolgen kann. Wenn die Schraube 14 angezogen ist, befindet sich ihr Kopf auf einer solchen Höhe, dass der Bügel 21 nicht mehr nach rechts wandern kann, da der Kopf der Schraube 14 idealer breiter ist als der untere Teil des Bügels 21 bzw. die untere Aussparung 21.1 am Bügel 21, die nur so breit ist, dass der Schaft 33 der Schraube 14 durch ihn hindurchpasst (siehe Figuren 4 und 5). Somit kann dann keine Entriegelung des Verriegelungsrahmens 19 mehr erfolgen.

Zusammenfassend kann gesagt werden, dass aufgrund des erfindungsgemäßen Verriegelungsrahmes 19 in Verbindung mit der erfindungsgemäßen Grundplatte 6 über den Hebelmechanismus 17 in einfacher und dennoch sicherer Weise einerseits ermöglicht wird, die Ventilpatronen 8 sehr einfach auszuwechseln, wenn sich die Tragplatte 6 in ihrer Wartungsposition befindet und andererseits die Ventilpatronen 8 in der Arbeitsposition der Tragplatte 6 sicher verriegelt sind.

Die Ventilblöcke 4 wurden hinsichtlich ihrer Leistung, Sicherheit und Handhabbarkeit optimiert. Der Schwerpunkt bei der Optimierung liegt in der Erhöhung der Stabilität des einzelnen Ventilblocks 4 sowie in der Verbesserung der Verriegelung Vakuumventile 16. Da die Verriegelung und die Entriegelung der Vakuumpatronen 8 in einem Ventilblock 4 gemäß dem Stand der Technik unter Umständen aufwendig sein kann, wurde bei der Erfindung ein neuer Verriegelungsmechanismus entwickelt, mit dessen Hilfe sich alle Ventilpatronen 8 mit einer Handbewegung Verriegeln und Entriegeln lassen. Um die Leistung der Vakuumventile 16 zu verbessern, wurde ihre Masse reduziert, wodurch die Schaltzeiten verbessert wurden. Um die Vakuumventile 16 vor Verschmutzung zu schützen, ist eine Haube 9 aufgesetzt, die die komplette Ventilreihe einhaust. Anders als bei einer Beschichtungsstation gemäß dem Stand der Technik, sind bei der Erfindung alle Vorsteuer-Pneumatikventile (in den Figuren nicht dargestellt) direkt auf dem Ventilblock 4 angeschlossen, wodurch eine einfachere Montage ermöglicht wird.

### Bezugszeichenliste

- 1: Plattform
- 2: Beschichtungsrad
- 3: Beschichtungsstation
- 4: Ventilblock
- 5: Vakuumblock
- 6: Tragplatte
- 7: Schwenkgelenk
- 8: Ventilpatrone
- 9: Haube
- 10: Vertiefung
- 11: Absaugleitung
- 12: Luftzufuhr
- 13: Luftzufuhrkanal
- 14: Schraube
- 15: unteres Ende des Vakuumventils
- 16: Vakuumventil
- 17: Hebelmechanismus
- 18: Betätigungshebel
- 19: Verriegelungsrahmen
- 20: Lager für Hebelmechanismus
- 21: Bügel
- 21.1: Aussparung
- 22: erste Durchbrechung
- 23: zweite Durchbrechung
- 24: Ringnut
- 25: oberes Ende der Ventilpatrone
- 26: Führungsnut
- 27: Aufnahmeöffnung
- 28: Führungsschlitz
- 29: Stange
- 30: Achse
- 31: Ventilgehäuse
- 32: Kolben
- 33: Schaft der Schraube 14
- 34: Kolbenstange

## Patentansprüche

1. Vorrichtung zum Beschichten von Behältern mit mindestens einem Ventilblock (4), wobei der Ventilblock (4) einen Vakuumblock (5) mit einer Vertiefung (10), in der Absaugleitungen (11) zur Erzeugung eines Abgasstroms vorhanden sind, und eine Tragplatte (6) aufweist, an der eine Mehrzahl von Vakuumventilen (16) in Aufnahmeöffnungen (27) angeordnet sind, wobei die Tragplatte (6) bezüglich des Vakuumblocks (5) eine Arbeitsposition und eine Wartungsposition aufweist, wobei die unteren Enden (15) der Vakuumventile (16), die sich im Strom des Prozessgases befinden, in der Arbeitsposition innerhalb der Vertiefung (10) angeordnet sind und sich in der Wartungsposition außerhalb der Vertiefung (10) befinden,
**dadurch gekennzeichnet, dass**
an der Tragplatte (6) ein Verriegelungsrahmen (19) angeordnet ist, der zwischen einer Verriegelungsposition und einer Entriegelungsposition relativ zur Tragplatte (6) bewegbar ist, so dass die Vakuumventile (16) in der Verriegelungsposition unlösbar mit der Tragplatte (6) verbunden sind und in der Entriegelungsposition von der Tragplatte (6) abnehmbar sind.

2. Vorrichtung nach Anspruch 1, wobei der Verriegelungsrahmen (19) einen Hebelmechanismus (17) aufweist, der an der Tragplatte (6) in einem Lager (20) gelagert ist, und mit dem die Bewegung des Verriegelungsrahmens (19) zwischen seiner Verriegelungsposition und seiner Entriegelungsposition erfolgt.

3. Vorrichtung nach Anspruch 2, wobei der Hebelmechanismus (17) einen Rastbolzen aufweist.

4. Vorrichtung nach einem der vorhergehenden Ansprüche, wobei der Verriegelungsrahmen (19) in einer Führung mit Führungsnuten (26) linear verschiebbar gelagert ist.

5. Vorrichtung nach einem der vorhergehenden Ansprüche, wobei der Verriegelungsrahmen (19) erste Abschnitte aufweist, die erste Durchbrechungen (22) aufweisen, die so groß sind und so weit voneinander beabstandet sind, dass sie in der Entriegelungsposition des Verriegelungsrahmens (19) die Aufnahmeöffnungen (27) für die Vakuumventile (16) nicht überdecken, und zweite Abschnitte mit zweiten Durchbrechungen (23) aufweist, die jeweils nebeneinander liegende erste Abschnitte miteinander verbinden und die in der Verriegelungsposition des Verriegelungsrahmens (19) die Aufnahmeöffnungen (27) für die Vakuumventile (16) teilweise überdecken.

6. Vorrichtung nach Anspruch 5, wobei die Vakuumventile (16) jeweils eine Ringnut (24) aufweisen, die so mit den zweiten Abschnitten des Verriegelungsrahmens (19) zusammenwirken, dass die Begrenzungen der zweiten Durchbrechungen (23) in der Verriegelungsposition in die Ringnuten (24) eingreifen.

7. Vorrichtung nach einem der vorhergehenden Ansprüche, wobei die Vakuumventile (16) jeweils eine Ventilpatrone (8) aufweisen, in der ihre Verschleißteile zusammengefasst sind, wobei an der Ventilpatrone (8) bevorzugt die Ringnut (24) ausgebildet ist.

8. Vorrichtung nach einem der vorhergehenden Ansprüche, wobei der Vakuumblock (5) mit der Tragplatte (6) über ein Schwenkgelenk (7) verbunden ist.

9. Vorrichtung nach einem der vorhergehenden Ansprüche, wobei eine lösbare Schraube (14) zwischen Vakuumblock (5) und Tragplatte (6), insbesondere an der Tragplatte (6), angeordnet ist.

10. Vorrichtung nach Anspruch 9, wobei die Schraube (14) nur in ihrem Endbereich ein Gewinde aufweist und ihr Kolbenstange (33) ansonsten ohne das Gewinde ausgeführt ist, und idealerweise die Gewindelänge gleich oder geringer ist als die gewindefreie Kolbenstangelänge.

11. Vorrichtung nach einem der vorhergehenden Ansprüche, wobei ein Luftzufuhrkanal (13) so ausgestaltet ist, dass er sowohl in dem Vakuumblock (5) als auch in der Tragplatte (6) verläuft und immer unterbrochen ist, wenn sich die Tragplatte (6) nicht in ihrer Arbeitsposition befindet.

## Claims

1. Device for coating containers with at least one valve block (4), wherein the valve block (4) has a vacuum block (5) with a depression (10), in which suction lines (11) are provided for generating an exhaust gas flow, and a support plate (6), on which a plurality of vacuum valves (16) are arranged in receiving openings (27), wherein the support plate (6) has a working position and a maintenance position relative to the vacuum block (5), wherein the lower ends (15) of the vacuum valves (16), which are located in the flow of the process gas, are arranged within the depression (10) in the working position and are located outside the depression (10) in the maintenance position,
**characterized in that**
arranged on the support plate (6) is a locking frame (19), which can be moved relative to the support plate (6) between a locked position and an unlocked position, with the result that the vacuum valves (16) are connected to the support plate (6) in a non-releasable manner in the locked position and can be removed from the support plate (6) in the unlocked position.

2. Device according to claim 1, wherein the locking frame (19) has a lever mechanism (17), which is mounted on the support plate (6) in a mount (20) and with which the movement of the locking frame (19) between its locked position and its unlocked position is effected.

3. Device according to claim 2, wherein the lever mechanism (17) has a detent pin.

4. Device according to one of the preceding claims, wherein the locking frame (19) is mounted linearly displaceable in a guide with guide grooves (26).

5. Device according to one of the preceding claims, wherein the locking frame (19) has first sections, which have first through holes (22), which are so large and are spaced so far apart from each other that, in the unlocked position of the locking frame (19), they do not cover the receiving openings (27) for the vacuum valves (16), and has second sections with second through holes (23), which in each case connect to each other first sections lying next to each other and which, in the locked position of the locking frame (19), partially cover the receiving openings (27) for the vacuum valves (16).

6. Device according to claim 5, wherein the vacuum valves (16) each have an annular groove (24), which annular grooves interact with the second sections of the locking frame (19) such that the boundaries of the second through holes (23) engage in the annular grooves (24) in the locked position.

7. Device according to one of the preceding claims, wherein the vacuum valves (16) each have a valve cartridge (8), in which their closure parts are grouped together, wherein the annular groove (24) is preferably formed on the valve cartridge (8).

8. Device according to one of the preceding claims, wherein the vacuum block (5) is connected to the support plate (6) via a swivel joint (7).

9. Device according to one of the preceding claims, wherein a releasable bolt (14) is arranged between vacuum block (5) and support plate (6), in particular on the support plate (6).

10. Device according to claim 9, wherein the bolt (14) has a screw thread only in its end area and otherwise its shank (33) is designed without the screw thread, and ideally the length of the screw thread is the same as or smaller than the thread-free length of shank.

11. Device according to one of the preceding claims, wherein an air supply duct (13) is designed such that it runs both in the vacuum block (5) and in the support plate (6) and is always interrupted when the support plate (6) is not located in its working position.

## Revendications

1. Dispositif de revêtement de récipients avec au moins un bloc de soupape (4), le bloc de soupape (4) comportant un bloc sous vide (5) doté d'un renfoncement (10) dans lequel des conduites d'évacuation (11) sont prévues pour produire un flux de gaz d'échappement et une plaque portante (6) au niveau de laquelle une pluralité de soupapes sous vide (16) sont disposées dans les ouvertures réceptrices (27), la plaque portante (6) présentant une position de travail et une position d'entretien par rapport au bloc sous vide (5), les extrémités inférieures (15) des soupapes sous vide (16) se trouvant dans le flux du gaz de procédé étant disposées dans la position de travail à l'intérieur du renfoncement (10) et se trouvant dans la position d'entretien à l'extérieur du renfoncement (10) ;
**caractérisé en ce que** :
un cadre de verrouillage (19) est disposé au niveau de la plaque portante (6), ledit cadre pouvant être déplacé entre une position de verrouillage et une position de déverrouillage par rapport à la plaque portante (6), de sorte que les soupapes sous vide (16) soient reliées de façon inamovible avec la plaque portante (6) dans la position de verrouillage et puissent être retirées de la plaque portante (6) dans la position de déverrouillage.

2. Dispositif selon la revendication 1, le cadre de verrouillage (19) comportant un mécanisme de levier (17) disposé dans un palier de roulement (20) au niveau de la plaque portante (6) et avec lequel le mouvement du cadre de verrouillage (19) est réalisé entre sa position de verrouillage et sa position de déverrouillage.

3. Dispositif selon la revendication 2, le mécanisme de levier (17) comportant un boulon d'arrêt.

4. Dispositif selon l'une quelconque des revendications précédentes, le cadre de verrouillage (19) étant disposé de façon linéaire dans un guide pourvu de rainures de guidage (26) de façon à pouvoir y coulisser.

5. Dispositif selon l'une quelconque des revendications précédentes, le cadre de verrouillage (19) comportant des premières sections comportant des premières brèches (22) qui sont espacées d'une hauteur et d'une largeur telles les unes par rapport aux autres qu'elles ne recouvrent pas, dans la position de déverrouillage du cadre de verrouillage (19), les ouvertures réceptrices (27) prévues pour les soupapes sous vide (16) et comportent des deuxièmes sections dotées de deuxièmes brèches (23) reliant respectivement entre elles des premières sections reposant côte à côte et recouvrant en partie dans la position de verrouillage du cadre de verrouillage (19) les ouvertures réceptrices (27) prévues pour les soupapes sous vide (16).

6. Dispositif selon la revendication 5, les soupapes sous vide (16) comportant respectivement une rainure annulaire (24) interagissant de telle sorte avec les deuxièmes sections du cadre de verrouillage (19) que les délimitations des deuxièmes brèches (23) s'imbriquent dans les rainures annulaires (24) dans la position de verrouillage.

7. Dispositif selon l'une quelconque des revendications précédentes, les soupapes sous vide (16) comportant respectivement un chargeur de soupape (8) dans lequel leurs parties d'usure sont rassemblées, la rainure annulaire (24) étant réalisée de façon préférée au niveau du chargeur de soupape (8).

8. Dispositif selon l'une quelconque des revendications précédentes, le bloc sous vide (5) étant relié à la plaque portante (6) via une articulation pivotante (7).

9. Dispositif selon l'une quelconque des revendications précédentes, une vis amovible (14) étant disposée entre le bloc sous vide (5) et la plaque portante (6), notamment au niveau de la plaque portante (6).

10. Dispositif selon la revendication 9, la vis (14) ne comportant un filet que dans sa zone d'extrémité et sa barre de piston (33) étant sinon réalisée sans le filet et idéalement, la longueur du filet étant inférieure ou égale à la longueur de la barre de piston sans filet.

11. Dispositif selon l'une quelconque des revendications précédentes, un canal d'alimentation en air (13) étant configuré de telle sorte qu'il s'étende tant dans le bloc sous vide (5) que dans la plaque portante (6) et soit toujours interrompu lorsque la plaque portante (6) ne se trouve pas dans sa position de travail.
